(19) Europäisches Patentamt
European Patent Office
Office européen des brevets

(11) **EP 2 130 239 B1**

(12) **EUROPÄISCHE PATENTSCHRIFT**

(45) Veröffentlichungstag und Bekanntmachung des Hinweises auf die Patenterteilung:
**24.06.2015 Patentblatt 2015/26**

(21) Anmeldenummer: **08717191.4**

(22) Anmeldetag: **27.02.2008**

(51) Int Cl.:
*H01L 41/187* (2006.01)     *H01L 41/083* (2006.01)
*C04B 35/493* (2006.01)     *C04B 35/491* (2006.01)

(86) Internationale Anmeldenummer:
**PCT/EP2008/052385**

(87) Internationale Veröffentlichungsnummer:
**WO 2008/107353 (12.09.2008 Gazette 2008/37)**

(54) **PIEZOELEKTRISCHES MATERIAL, VIELSCHICHT-AKTUATOR UND VERFAHREN ZUR HERSTELLUNG EINES PIEZOELEKTRISCHEN BAUELEMENTS**

PIEZO-ELECTRIC MATERIAL, MULTI-LAYER ACTUATOR AND METHOD FOR PRODUCING A PIEZO-ELECTRIC COMPONENT

MATÉRIAU PIÉZOÉLECTRIQUE, ACTIONNEUR MULTICOUCHES ET PROCÉDÉ DE FABRICATION D'UN COMPOSANT PIÉZOÉLECTRIQUE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **02.03.2007 DE 102007010239**

(43) Veröffentlichungstag der Anmeldung:
**09.12.2009 Patentblatt 2009/50**

(73) Patentinhaber: **Epcos AG**
**81669 München (DE)**

(72) Erfinder:
• **FELTZ, Adalbert**
**8530 Deutschlandsberg (AT)**

• **SCHOSSMANN, Michael**
**8530 Deutschlandsberg (AT)**
• **SCHMIDT-WINKEL, Patrick**
**65510 Hünstetten (DE)**

(74) Vertreter: **Epping - Hermann - Fischer**
**Patentanwaltsgesellschaft mbH**
**Schloßschmidstraße 5**
**80639 München (DE)**

(56) Entgegenhaltungen:
EP-A- 0 065 806      WO-A-2007/074095
WO-A1-2005/069396      US-A- 5 433 917
US-A- 5 792 379      US-A1- 2003 207 150
US-B1- 6 182 340

EP 2 130 239 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein piezoelektrisches Material, das für die Herstellung von piezoelektrischen Bauelementen mit Innenelektroden geeignet ist. Darüber hinaus betrifft die Erfindung einen piezoelektrischen Vielschicht-Aktuator und ein Verfahren zur Herstellung eines piezoelektrischen Bauelements.

Aus der Druckschrift DE 102004002204 A1 ist ein piezoelektrisches Keramikmaterial bekannt.

WO 2005/069396 offenbart ein keramisches Material mit der folgenden allgemeinen Formel:

$A_{1-b-c}B_bC_c$, worin: $0 \leq b \leq 0.5$ und $0 \leq c \leq 0.01$ und worin

- A die Zusammensetzung $Pb(Zr_aTi_{1-a})O_3$ darstellt und worin: $0,5 \leq a \leq 0,6$,
- B eine zusätzliche Komponente mit einer Struktur vom Kryolith-Typ darstellt.

Eine zu lösende Aufgabe besteht darin, ein piezoelektrisches Material anzugeben, das gut für die Anwendung in piezoelektrischen Vielschicht-Aktuatoren geeignet ist.

Es wird ein piezoelektrisches Material beschrieben, das auf der Basis von PZT (Blei-Zirkonat-Titanat) hergestellt ist.

Die Anwendung von piezoelektrischen Bauelementen als Aktuatoren setzt, besonders in der Automobil-Technik, hohe Anforderungen an Zuverlässigkeit sowie zeitliche und thermische Stabilität. Darüber hinaus verlangt diese Anwendung hohe dynamische Aktuatorauslenkungen in Kombination mit hoher Blockierkraft, die bei Anlegen einer elektrischen Spannung an den Aktuator resultieren. Besonders geeignete Materialien sind piezoelektrische Keramiken basierend auf Blei-Zirkonat-Titanat ($Pb(Zr_{1-y}Ti_y)O_3$, PZT). Die gewünschten piezoelektrischen Materialeigenschaften werden im Fall von PZT-Keramiken zunächst erreicht durch Einstellung eines bestimmten Mengenverhältnisses zwischen Zirkon (Zr) und Titan (Ti) in der Perowskit-Struktur ($ABO_3$-Typ) von PZT entsprechend der allgemeinen Formel $Pb(Zr_{1-y}Ti_y)O_3$. Besonders vorteilhafte piezoelektrische Eigenschaften werden mit PZT-Materialien erreicht, wenn das Zr/Ti-Verhältnis im Bereich der so genannten morphotropen Phasengrenze (MPG) liegt. Es werden daher bevorzugt PZT Materialien gemäß $Pb(Zr_{1-y}Ti_y)O_3$ mit y~0,45-0,50 gewählt. Darüber hinaus lassen sich die Materialeigenschaften von PZT durch Zusatz von bestimmten Stoffen, die sich in der Perowskit-Struktur von PZT lösen können und auch als Dotierstoffe oder Dotanden bezeichnet werden, sehr weitgehend und spezifisch auf die jeweilige Anwendung einstellen. Die Modifikation eines PZT-Materials kann dabei beispielsweise durch Substitution von Blei (Pb) auf A-Plätzen (Pb-Plätze) und/oder durch Substitution von Zr/Ti auf B-Plätzen (Zr/Ti-Plätze) durch geeignete Elemente oder geeignete Kombinationen von Elementen erreicht werden. Für die thermische Stabilität der Eigenschaften von piezoelektrischen PZT-Materialien ist es dabei vorteilhaft, die vergleichsweise hohe Curietemperatur von $T_C$~360°C durch derartige Materialmodifikationen nicht zu stark abzusenken. Dies gelingt vor allem dadurch, dass die Konzentrationen der Zusatzstoffe oder Dotanden möglichst klein gehalten werden.

Das hier beschriebene piezoelektrische Material enthält neben dem PZT-Grundmaterial einen Zusatz, der in Form eines solchen Dotierstoffs vorliegt. Mit Hilfe eines Zusatzes zum PZT-Grundmaterial können Gitterplätze des PZT-Grundgitters mit anderen als den von PZT vorgegebenen Materialien besetzt werden, wodurch die elektrischen und mechanischen Eigenschaften des Materials günstig beeinflusst werden können. Vorzugsweise liegt der Dotierstoff in einem Anteil von bis zu 2,5 mol-% in dem piezoelektrischen Material vor.

Besonders bevorzugt bildet sich aus dem PZT-Grundmaterial und dem Dotierstoff ein Mischkristall, wobei das Blei-Zirkonat-Titanat und der Dotierstoff eine feste Lösung bilden. Mit Hilfe der Dotierung von PZT gelingt insbesondere der Einbau von Kationen auf B-Plätzen des PZT-Wirtsgitters, wodurch die elektrischen Eigenschaften des Materials besonders weitgehend verbessert werden können.

Besonders bevorzugt kommt als Dotierstoff ein Keramikmaterial in Betracht, das der allgemeinen Formel $[(M_1O)_{1-p}(M_2O)_p]_a[Nb_2O_5]_{1-a}$ entspricht, wobei $M_1$ für $Ba_{1-t}Sr_t$ mit $0 \leq t \leq 1$ und $M_2$ für Strontium oder Kalzium steht und wobei gilt: $2/3 < a < 1$ und $0 < p < 1$.

Mit Hilfe der angegebenen Mischung aus PZT und dem Dotierstoff der angegebenen Formel gelingt der Einbau von $M_2$ Kationen auf die formalen B-Plätze des Perowskit-Wirtsgitters. Dies gilt insbesondere deshalb, da das PZT-Grundmaterial und der Dotierstoff einen Mischkristall bilden. Als PZT-Grundmaterial kommt insbesondere die Zusammensetzung $Pb(Zr_{1-y}Ti_y)O_3$ in Betracht, wobei gilt: $0,50 \leq 1-y \leq 0,60$, und wobei das Wirtsgitter dem Gittertyp $ABO_3$ vom Perowskit-Typ entspricht. Mit der Wahl des Parameters 1-y zwischen 0,5 und 0,6 wird das Zirkon/Titan-Verhältnis auf den Bereich der so genannten morphotropen Phasengrenze eingestellt, was besonders gute Eigenschaften für das keramische Material bewirkt.

Gemäß einer weiteren Ausführungsform des piezoelektrischen Materials kann darüber hinaus noch eine Zusatzkomponente vom Perowskit-Strukturtyp in einem Anteil von bis zu 50 mol-% enthalten sein.

Der Dotierstoff kann den Kryolith-Strukturtyp enthalten, wodurch sich eine besonders gute Löslichkeit des Dotierstoffs beziehungsweise von Teilen des Dotierstoffs im PZT-Wirtsgitter ergibt.

Der Dotierstoff kann als Verbindung mit Kryolith-Struktur im Wirtsgitter in fester Lösung vorliegen.

Hinsichtlich des Dotierstoffs können drei unterschiedliche stöchiometrische Zusammensetzungen beziehungsweise Parameterbereiche unterschieden werden:

Im Parameterbereich 1 gilt: $6/7 < a < 1$.

Im Parameterbereich 2 gilt: $2/3 < a < 4/5$.

Im Parameterbereich 3 gilt: $4/5 \leq a \leq 6/7$ und $1/4 \leq p \leq 1/3$.

Im Parameterbereich 3 ergibt sich für den Dotierstoff eine Formulierung einer Verbindung mit Kryolith-Struktur für den Fall, dass sich der Parameter p korreliert mit dem Parameter a ändert und zwar gemäß der Beziehung $a = 22/35 + 24p/35$, die einen Zusammenhang zwischen a und p herstellt. Die allgemeine Formel für das zugrunde liegende Kryolith-System lautet dann

$(M_1)_4[(M_2)_{2-2x/3}Nb_{2+2x/3}]O_{11+x}V_{O;1-x}$ mit $0 \leq x \leq 1$, wobei für den Zusammenhang zwischen a und dem Parameter x gilt:

$$a = 6/7 - 2x/35.$$

Entsprechend der Variationsbreite $0 \leq x \leq 1$ und dem Vorhandensein von Sauerstoffleerstellen ($V_O$) weist die Kryolith-Verbindung eine Phasenbreite auf. Zudem entspricht die Kryolith-Struktur sehr gut dem eng verwandten PZT-Perowskit-Wirtsgitter. Beide Keramikmaterialien können ein Mischkristallsystem bilden, in dem sich die Bestandteile des Dotierstoffes auf den Gitterplätzen des PZT-Wirtsgitters einfügen. Sie bilden somit eine feste Lösung, das heißt in der Perowskit-Phase treten im Bereich x < 1 Leerstellen auf den Sauerstoffplätzen auf und $M_2$ wird auf den B-Plätzen der einheitlichen Perowskit-Phase eingebaut.

Für den Fall, dass $M_1 = M_2 = Sr$ gilt, werden Strontium-Kationen auf den B-Plätzen der Perowskit-Phase eingebaut.

Im Parameterbereich 1 geht der vorhandene Überschuss {$M_1O$ und/oder $M_2O$} in den Grenzen von 1/7 (für a = 1) und O (für a = 6/7) mit dem PZT-Wirtsgitter eine chemische Reaktion ein.

Für den Überschuss an Erdalkalioxid kann das Verhältnis von $M_1$ zu $M_2$ entsprechend $0 < p < 1$ beliebig variiert werden und es können folgende Reaktionen stattfinden:

$M_1O + Pb(Zr_{1-y}Ti_y)O_3 \leftrightarrows M_1(Zr_{1-y}Ti_y)O_3 + PbO$ \hfill Gleichung < 1a >

$M_2O + Pb(Zr_{1-y}Ti_y)O_3 \leftrightarrows M_2(Zr_{1-y}Ti_y)O_3 + PbO$ \hfill Gleichung < 1b >

Mit Hilfe dieser Reaktionen kann das PbO aus dem PZT-Wirtsgitter verdrängt werden, und es wird eine äquivalente Menge $M(Zr_{1-y}Ti_y)O_3$ gebildet, wobei M für $M_1$ oder $M_2$ steht. Diese gebildeten Zirkonat-Titanate können sich im PZT-Wirtsgitter gleichfalls unter Mischkristallbildung lösen. Außerdem entsteht Bleioxid, das den Anteil am gegebenenfalls im System ohnehin vorhandenen Sinterhilfsmittel geringfügig weiter erhöht. Die genannte Reaktion kann ablaufen, solange, bis a = 6/7 erreicht ist. In diesem Fall ist ein dem $Nb_2O_5$-Gehalt äquivalenter Anteil an $M_1O$ und/oder $M_2O$ in dem Material vorhanden und es ergibt sich mit p = 1/3 die feste Lösung der Kryolith-Verbindung mit der Grenzzusammensetzung $(M_1)_4[(M_2)_2Nb_2]O_{11}V_{O;1}$ im PZT-Wirtsgitter. Die feste Lösung enthält $M_2$-Kationen auf B-Plätzen des Perowskit-Mischkristalls und Sauerstoff-Leerstellen.

Diese Grenzzusammensetzung entspricht dem Parameter x = O entsprechend der einen Seite der Phasenbreite des Kryolith-Systems. In diesem Fall ist die Sauerstoff-Leerstellenkonzentration verhältnismäßig hoch.

Für den Fall $M_1 = M_2 = Sr$ besteht ein Überschuss an Strontiumoxid in den Grenzen $0 < \{SrO\} < 1/7$. Die Verdrängung von PbO aus dem PZT-Wirtsgitter verläuft gemäß der folgenden Reaktionsgleichung:

$SrO + Pb(Zr_{1-y}Ti_y)O_3 \leftrightarrows Sr(Zr_{1-y}Ti_y)O_3 + PbO$ \hfill Gleichung < 2 >

Mit Hilfe dieser Reaktion wird eine äquivalente Menge an $Sr(Zr_{1-y}Ti_y)O_3$ gebildet, das sich im PZT-Wirtsgitter unter Mischkristallbildung löst. Ein dem $Nb_2O_5$-Gehalt äquivalenter Anteil an SrO, entsprechend einem Überschuss an Strontiumoxid von 0, ergibt die Ausbildung einer festen Lösung der Kryolith-Verbindung mit der Grenzzusammensetzung $Sr_4(Sr_2Nb_2)O_{11}V_{O;1}$ im PZT-Wirtsgitter gemäß der anderen Seite der Phasenbreite im Kryolith-System. Die feste Lösung enthält Sr-Kationen auf B-Plätzen des Perowskit-Mischkristalls und Sauerstoff-Leerstellen.

Im Parameterbereich 2 liegt ein Überschuss von Nioboxid $\{Nb_2O_5\}$ in den Grenzen $1/5 > \{Nb_2O_5\} > 0$ vor, der infolge einer Bindung von gegebenenfalls im System vorhanden beziehungsweise dem System zuzugebendem Sinterhilfsmittel PbO gemäß

$$Nb_2O_5 + PbO \leftrightarrows 2\ Pb_{0,5}V_{Pb;0,5}NbO_3 \qquad \text{Gleichung} < 3 >$$

zur Bildung einer äquivalenten Menge Bleiniobat führt. Das Bleiniobat kann sich im PZT-Gitter ebenfalls unter Mischkristallbildung lösen, wobei es zur Ausbildung von Blei-Leerstellen $V_{Pb}$ auf den Pb-Plätzen des PZT-Wirtsgitters kommt. Für einen dem $M_1O$ beziehungsweise $M_2O$-Gehalt äquivalenten Anteil an $Nb_2O_5$ entsprechend $a = 4/5$ ergibt sich bei Einhaltung des Parameters $p = 1/4$ die Ausbildung einer festen Lösung der Kryolith-Verbindung mit der Grenzzusammensetzung $(M_1)_4[(M_2)_{4/3}Nb_{8/3}]O_{12}$ im PZT-Wirtsgitter gemäß der anderen Seite der Phasenbreite des Kryolith-Systems, wobei in diesem Fall weiterhin $M_2$-Kationen auf B-Plätzen des Perowskit-Mischkristalls vorhanden, die Sauerstoff-Leerstellen jedoch eliminiert sind.

Für den Fall $M_1 = M_2 = Sr$ entfällt der Parameter p und es ergibt sich für den Fall eines dem Strontiumoxid-Gehalts äquivalenten Anteil an $Nb_2O_5$ die Ausbildung einer festen Lösung der Kryolith-Verbindung mit der Grenzzusammensetzung $Sr_4(Sr_{4/3}Nb_{8/3})O_{12}$ gemäß der anderen Seite der Phasenbreite des Kryolith-Systems, wobei keine Sauerstoff-Leerstellen vorhanden sind, jedoch enthalten die B-Plätze des Perowskit-Mischkristalls weiterhin Sr-Kationen.

Ganz allgemein gilt für sämtliche hier beschriebenen piezoelektrischen Materialien, dass diese zusätzlich bis zu 5 mol-% an PbO enthalten können. Dieses Bleioxid kann beispielsweise als Hilfsmittel beim Sintern des Keramikmaterials dienen.

Gemäß einer besonders bevorzugten Ausführungsform des Materials enthält der Dotierstoff eine Kryolith-Verbindung der Formel $(M_1)_4[(M_2)_2Nb_2]O_{11}V_{O;1}$, die eine feste Lösung mit dem PZT-Wirtsgitter bildet.

Allgemein kann das hier beschriebene piezoelektrische Material mit der Summenformel $P_{1-c-d}D_cZ_d$, beschrieben werden wobei gilt:

$$0,0255 < c < 0,0443 \text{ und } 0 \le d \le 0,5.$$

Dabei steht P für den PZT-Grundstoff, D für den Dotierstoff der allgemeinen Zusammensetzung $[(M_1O)_{1-p}(M_2O)_p]_a[Nb_2O_5]_{1-a}$ und Z für eine Zusatzkomponente vom Perowskit-Strukturtyp.

Die Kryolith-Verbindung der Formel $(M_1)_4[(M_2)_2Nb_2]O_{11}V_{O;1}$ kann Bestandteil der Komponente D sein, wobei der Überschuss an MO der Komponente D mit der Komponente P zu $M(Zr_{1-y}Ti_y)O_3$ und PbO reagiert ist, wobei M für $M_1$ oder $M_2$ steht.

Gemäß einer anderen Ausführungsform des Materials kann der Dotierstoff eine Kryolith-Verbindung gemäß der Formel $(M_1)_4[(M_2)_{4/3}Nb_{8/3}]O_{12}$ enthalten, die eine feste Lösung mit dem PZT-Wirtsgitter bildet. Die Kryolith-Verbindung kann Bestandteil der Komponente D sein, wobei ein Überschuss an $Nb_2O_5$ der Komponente D mit zusätzlich vorhandenem PbO in dem Keramikmaterial zu Bleiniobat reagiert ist.

Gemäß einer Ausführungsform des Materials kann in dem Material $M(Zr_{1-y}Ti_y)O_3$ enthalten sein als Produkt einer Reaktion des beschriebenen Kryolith-Systems mit der Komponente P, wobei M für $M_1$ oder $M_2$ steht.

Aufgrund der nur in geringen Mengen zugesetzten Dotierstoffe kann für die Kryolith-Verbindung des Dotierstoffs eine Wechselwirkung und Reaktion mit dem in großem Überschuss vorhandenen PZT-Wirtsgitter zustande kommen. Auf diese Weise kann eine erhebliche Änderung der Sauerstoff-Leerstellenkonzentration im gesamten Materialsystem erreicht werden.

Aufgrund der größeren Basizität der Erdalkalioxid-Komponente im Dotierstoff schließt die Mischkristallbildung des Dotierstoffs mit dem PZT-Wirtsgitter die Möglichkeit der Verdrängung von PbO aus PZT ein. Dies gilt vor allem im Bereich der Formulierung einer festen Lösung einer Verbindung aus dem beschriebenen Kryolith-System im PZT-Wirtsgitter. Die in Betracht kommenden Reaktionen lauten wie folgt:

$$(M_1)_4[(M_2)_2Nb_2]O_{11}V_O + 8/7\ Pb(Zr_{1-y}Ti_y)O_3 \leftrightarrows 6/7\ (M_1)_4[(M_2)_{5/3}Nb_{7/3})]O_{11,5}V_{O;0,5} + 4/7\ M_1(Zr_{1-y}Ti_y)O_3 + 4/7\ M_2(Zr_{1-y}Ti_y)O_3 + 8/7\ PbO \qquad \text{Gleichung} < 4 >$$

$$6/7\ (M_1)_4[(M_2)_{5/3}Nb_{7/3})]O_{11,5}V_{O;0,5} + 6/7\ Pb(Zr_{1-y}Ti_y)O_3 \leftrightarrows 3/4\ (M_1)_4[(M_2)_{4/3}Nb_{8/3}]O_{12} + 3/7\ (M_1)Sr(Zr_{1-y}Ti_y)O_3 + 3/7\ M_2(Zr_{1-y}Ti_y)O_3 + 6/7\ PbO \qquad \text{Gleichung} < 5 >$$

$$3/4\ (M_1)_4[(M_2)_{4/3}Nb_{8/3}]O_{12} + 4\ Pb(Zr_{1-y}Ti_y)O_3 \leftrightarrows 3\ M_1(Zr_{1-y}Ti_y)O_3 + 2\ Pb_{0,5}V_{Pb;0,5}NbO_3 + 3\ PbO + 1\ M_2(Zr_{1-y}Ti_y)O_3 \qquad \text{Gleichung} < 6 >$$

Gleichung <6> würde bei vollständigem Ablaufen einen vollständigen Übertritt der $M_2$-Kationen von den B-Plätzen des Wirtsgitters auf die A-Plätze des Wirtsgitters bedeuten.

Mit der letzten Reaktionsgleichung ist die Bildung von $PbNb_2O_6$ verbunden, was äquivalent ist zu 2 Formeleinheiten $Pb_{0,5}V_{Pb;0,5}NbO_3$. Infolge einer Mischkristallbildung mit dem PZT-Wirtsgitter kommt es zur Ausbildung von Blei-Leerstellen auf den A-Plätzen der dotierten PZT-Keramik.

Entsprechend den angegebenen Reaktionsgleichungen wird ein piezoelektrisches Material angegeben, wobei $(M_1)_4[(M_2)_{4/3}Nb_{8/3}]O_{12}$ mit dem PZT-Wirtsgitter zumindest teilweise zu Bleiniobat umgesetzt ist.

Darüber hinaus wird auch ein piezoelektrisches Material angegeben, wobei $(M_1)_4[(M_2)_{5/3}Nb_{7/3}]O_{11,5}V_{O;0,5}$ mit dem PZT-Wirtsgitter zumindest teilweise zu $(M_1)_4[(M_2)_{4/3}Nb_{8/3}]O_{12}$ umgesetzt ist.

Darüber hinaus wird auch ein piezoelektrisches Material angegeben, wobei $(M_1)_4[(M_2)_2Nb_2]O_{11}V_O$ mit PZT-Wirtsgitter zumindest teilweise zu $(M_1)_4[(M_2)_5/3Nb_{7/3}]O_{11,5}V_{O;0,5}$ umgesetzt ist.

Die angegebenen Reaktionen erlauben die Einstellung einer sehr variablen Konzentration der Sauerstoff-Leerstellen. Diese Erhöhung beziehungsweise Absenkung der Sauerstoff-Leerstellenkonzentration kann temperaturabhängig erfolgen, was eine gute Möglichkeit für den vorteilhaften Einsatz der Sauerstoff-Leerstellenvariation im Sinterprozess des Keramikmaterials bietet. Dies wird im Folgenden erläutert.

Der gemäß den genannten Gleichungen stattfindenden Verdrängung von PbO aus dem PZT-Wirtsgitter kann durch die stärkere Basizität des Erdalkalioxids im Dotierstoff ein exothermer Reaktionsverlauf zugrunde gelegt werden. Dies bedeutet, dass sich die Gleichgewichte bei hohen Temperaturen in Richtung einer erhöhten Konzentration an Sauerstoff-Leerstellen verlagern, wodurch die Sinterverdichtung und das Kornwachstum der Keramik gefördert wird. Beim Abkühlen verlagern sich die Gleichgewichte auf die Seite einer Verminderung der Konzentration der Sauerstoff-Leerstellen, die bis zur vollständigen Eliminierung derartiger Defekte führen kann, was für die Funktionsstabilität der PZT-Keramik von Vorteil ist.

Auf der Basis der angegebenen Reaktionsgleichungen kann das Verteilungsmuster der durch den Dotierstoff im PZT-Wirtsgitter eingebauten Defekte im Rahmen der thermischen Prozessierung gesteuert werden. Dadurch verändert sich die Zusammensetzung der festen Lösung aus PZT-Grundmaterial und Dotierstoff.

Es wird dementsprechend auch ein piezoelektrisches Material angegeben, das eine Blei-Zirkonat-Titanat-Keramik enthält, wobei die Keramik Sauerstoff-Leerstellen an Gitterplätzen des PZT-Gitters aufweist, und wobei die Konzentration der Sauerstoff-Leerstellen temperaturabhängig ist.

Darüber hinaus wird gemäß einer Ausführungsform ein Material angegeben, wobei die Konzentration der Sauerstoff-Leerstellen mit steigender Temperatur zunimmt.

In einer besonders bevorzugten Ausführungsform verläuft die Sauerstoff-Leerstellenkonzentration weitgehend temperaturabhängig in einem Temperaturbereich zwischen 0 und 1200 °C. Dieses Material hat den Vorteil, dass die Temperaturabhängigkeit der Sauerstoff-Leerstellenkonzentration in einem Sinterprozess zur Herstellung des keramischen Materials nutzbar gemacht werden kann. Dabei liegt die Sintertemperatur für die hier vorgegebenen Materialien zwischen 900 und 1200 °C.

Gemäß einer besonderen Ausführungsform des piezoelektrischen Materials wird der Bestandteil der Kationen so gewählt, dass gilt:

$$M_1 = M_2 = Sr.$$

Daraus resultieren Verbindungen aus dem beschriebenen Kryolith-System gemäß der Formel

$Sr_4(Sr_{2-2x/3}Nb_{2+2x/3})O_{11+x}V_{O;1-x}$, wobei gilt: $0 \le x \le 1$. Ein Teil der Strontium-Kationen besetzt dabei die formalen B-Plätze des Perowskit-Wirtsgitters der Komponente P. Das angegebene Material kann als Produkt einer Reaktion der Komponente P mit der Komponente D das Material $Sr(Zr_{1-y}Ti_y)O_3$ enthalten. Dieses Material kann in Form einer festen Lösung mit dem PZT-Wirtsgitter vorliegen.

Die Reaktionen zwischen dem Dotierstoff und dem PZT-Wirtsgitter können in diesem Fall wie folgt lauten:

$Sr_4(Sr_2Nb_2)O_{11}V_O$ + 8/7 $Pb(Zr_{1-y}Ti_y)O_3$ $\leftrightarrows$ 6/7 $Sr_4(Sr_{5/3}Nb_{7/3})O_{11,5}V_{O;0,5}$ + 8/7 $Sr(Zr_{1-y}Ti_y)O_3$ + 8/7 PbO   Gleichung < 7 >

6/7 $Sr_4(Sr_{5/3}Nb_{7/3})O_{11,5}V_{O;0,5}$ + 6/7 $Pb(Zr_{1-y}Ti_y)O_3$ $\leftrightarrows$ 3/4 $Sr_4(Sr_{4/3}Nb_{8/3})O_{12}$ + 6/7 $Sr(Zr_{1-y}Ti_y)O_3$ + 6/7 PbO   Gleichung < 8 >

3/4 $Sr_4(Sr_{4/3}Nb_{8/3})O_{12}$ + 4 $Pb(Zr_{1-y}Ti_y)O_3$ $\leftrightarrows$ 4 $Sr(Zr_{1-y}Ti_y)O_3$ + 2 $Pb_{0,5}V_{Pb;0,5}NbO_3$ + 3 PbO   Gleichung < 9 >

Gemäß einer besonderen Ausführungsform des Materials lautet die Zusammensetzung $P_{1-c-d}D_cZ_d[PbO]_m$,

wobei D für eine Kryolith-Verbindung gemäß der Formel $[(SrO)_a(Nb_2O_5)_{1-a}]$ mit a = 29/35 steht, die durch die äquivalente Kryolith-Schreibweise $Sr_4(Sr_{5/3}Nb_{7/3})O_{11,5}V_{0;0,5}$ wiedergegeben werden kann, wobei gilt:

$$0,0255 < c < 0,0443 \text{ und } 0 \leq m \leq 0,05, \text{ } d = 0.$$

In einem Referenzbeispiel wird ein Material angegeben, das für 1-y = 0,53 mit c = 0,005 und m = 0,01 eine Zusammensetzung gemäß der Formel
$[Pb(Zr_{0,53}Ti_{0,47})O_3]_{0,973}[Sr_4(Sr_{4/3}Nb_{8/3})O_{12}]_{0,00213}$
$[Sr(Zr_{0,53}Ti_{0,47})O_3]_{0,017}[PbV_{Pb}(Nb_2O_6)]_{0,003}(PbO)_{0,029}$ aufweist.

Bei dem Keramikmaterial des Referenzbeispiels besetzen etwa 10 % der Strontium-Kationen die formalen B-Plätze des PZT-Wirtsgitters.

Gemäß einer anderen Ausführungsform wird ein piezoelektrisches Material angegeben, mit der Zusammensetzung $P_{1-c-d}D_cz_d[PbO]_m$, wobei D für eine Kryolith-Verbindung gemäß der Formel $[(BaO)_{1-p}(CaO)_p]_a(Nb_2O_5)_{1-a}]$ mit a = 29/35 und p = 7/24 steht, die durch die äquivalente Kryolith-Schreibweise $Ba_4(Ca_{5/3}Nb_{7/3})O_{11,5}V_{0;0,5}$ wiedergegeben werden kann, wobei gilt:

$$0,0255 < c < 0,0443 \text{ und } 0 \leq m \leq 0,05, \text{ } d = 0.$$

Gemäß einem Referenzbeispiel wird ein Material angegeben, das für 1-y = 0,53 mit c = 0,005 und m = 0,01 eine Zusammensetzung gemäß der Formel
$[Pb(Zr_{0,53}Ti_{0,47})O_3]_{0,973}[Ba_4(Ca_{4/3}Nb_{8/3})O_{12}]_{0,00213}$
$[Ba(Zr_{0,53}Ti_{0,47})O_3]_{0,0115}[Ca(Zr_{0,53}Ti_{0,47})O_3]_{0,0055}$
$[PbV_{Pb}(Nb_2O_6)]_{0,003}(PbO)_{0,029}$ aufweist.

In diesem Referenzbeispiel besetzen etwa 34 % der Calzium-Kationen formale B-Plätze des PZT-Wirtsgitters.

Im Folgenden wird noch einmal näher auf den Fall $M_1 = M_2 = Sr$ eingegangen.

Gemäß einer Ausführungsform wird als Dotand für die PZT-Keramik eine Strontium-Niobat-Mischung gemäß der Formel $(SrO)_a(Nb_2O_5)_{1-a}$ in den Grenzen 1 > a > 2/3 verwendet. Mit dem Einbau von $Nb^{5+}$-Kationen auf B-Plätzen der Perowskit-Struktur des PZT-Wirtsgitters ist eine Kontraktion von $NbO_{6/2}$-Oktaedern verbunden, wodurch eine Aufweitung benachbarter Sauerstoff-Oktaeder zustande kommt und damit verbunden der Einbau von vergleichsweise großen Sr-Kationen auf B-Plätzen des PZT-Wirtsgitters mit der Koordinationszahl = 6 ermöglicht wird.

Dabei ist zu beachten, dass $(SrO)_a(Nb_2O_5)_{1-a}$ mit dem Blei-Zirkonat-Titanat-Wirtsgitter unter Bildung von Strontium-Zirkonat-Titanat (SZT) in Wechselwirkung treten und in den Grenzen 1 > a > 2/3 $Pb(Nb_2O_6)$ (dies entspricht $Pb_{0,5}V_{Pb;0,5}NbO_3$) bilden kann, das sich im PZT-Wirtsgitter mit Blei-Leerstellen ($V_{Pb}$) auf den formalen A-Plätzen ebenso wie SZT unter Mischkristallbildung löst. Dies erfolgt gemäß der folgenden Reaktionsgleichung:

$$(SrO)_a(Nb_2O_5)_{1-a} + a\ Pb(Zr_{1-y}Ti_y)O_3 \leftrightarrows (1-a)PbNb_2O_6 + a\ Sr(Zr_{1-y}Ti_y)O_3 + (2a-1)PbO \quad \text{Gleichung} < 10 >$$

Im Bereich 1 > a > 6/7 reagiert $(SrO)_a(Nb_2O_5)_{1-a}$ mit PZT bis zum Erreichen von a = 6/7 unter Freisetzung von PbO, das zu der in der Mischung ohnehin vorhandenen geringen Menge von in der Regel 0,1-5 mol-% PbO additiv hinzukommt und als Sinterhilfsmittel wirkt.

$$SrO + Pb(Zr_{1-y}Ti_y)O_3 \leftrightarrows Sr(Zr_{1-y}Ti_y)O_3 + PbO \quad \text{Gleichung} < 2 >$$

Für den Fall mit a = 6/7 besteht die Option einer Mischkristallbildung im PZT-Wirtsgitter mit der Kryolith-Verbindung $Sr_4(Sr_2Nb_2)O_{11}V_{O;1}$, wobei Sr-Ionen auf B-Plätzen sowie Sauerstoff-Leerstellen enthalten sind. Die Mitwirkung dieser Kryolith-Verbindung im PZT/Dotierstoff-Mischkristallsystem kommt im gesamten Bereich mit den Grenzen 1 > a > 6/7 zum Tragen, das heißt mit dem Einbau von Nb-Kationen geht stets die Möglichkeit der Besetzung von B-Plätzen durch Sr-Kationen im PZT-Wirtsgitter einher.

Das Kryolith-System gemäß der Formel
$Sr_4(Sr_{2-2x/3}Nb_{2+2x/3})O_{11+x}V_{O;1-x}$ mit einer Phasenbreite innerhalb der Grenzen $0 \leq x \leq 1$ ist auf Grund einer Mischkristallbildung mit dem PZT-Perowskit-Wirtsgitter zur Dotierung von PZT-Keramiken besonders geeignet. Für Mischungen gemäß der allgemeinen Formel $(SrO)_a(Nb_2O_5)_{1-a}$ wird die Phasenbreite des Kryolith-Systems durch die Grenzen $6/7 \geq a \geq 4/5$ beschrieben. Mit dieser variablen Zusammensetzung innerhalb der Phasenbreite geht eine variable Konzentration der Sauerstoffleerstellen $V_O$ einher. Mit der Grenzzusammensetzung x = 0 (in diesem Fall gilt a = 6/7) ergibt sich beispielsweise die feste Lösung von $Sr_4(Sr_2Nb_2)O_{11}V_{O;1}$ im PZT-Wirtsgitter mit vergleichsweise hoher Sauerstoff-Leerstellenkonzentration von $[V_O]=1$. Für x = 1/2 (in diesem Fall gilt a = 34/41) folgt mit der entsprechenden Formel $Sr_4(Sr_{5/3}Nb_{7/3})O_{11,5}V_{O;0,5}$ eine mittlere Sauerstoff-Leerstellenkonzentration von $[V_O]=0,5$. Und im Fall der Grenzzusammensetzung mit x = 1 (in diesem Fall gilt a = 4/5) was der Formel $Sr_4(Sr_{4/3}Nb_{8/3})O_{12}$ entspricht, sind keine Sauerstoff-Leerstellen mehr vorhanden, denn es liegt jetzt Valenzkompensation auf den B-Plätzen vor, die eine Besetzung von B-Plätzen durch Sr-Kationen einschließt.

Für den Dotierstoff mit der Zusammensetzung $(SrO)_a(Nb_2O_5)_{1-a}$ im Bereich $4/5 \geq a \geq 2/3$ kommt auf Grund eines über die Grenzzusammensetzung des Kryolith-Systems hinausgehenden Anteils an $Nb_2O_5$ die Bildung der Verbindung $Pb_{0,5}V_{Pb;0,5}NbO_3$ mit Blei-Leerstellen ($V_{Pb}$) auf den A-Plätzen des PZT-Perowskit-Mischkristalls zustande, wobei ein Teil des als Sinterhilfsmittel zugesetzten Bleioxid (PbO) gebunden wird. Die in den Gleichungen <7>, <8> und <9> beschriebene Verdrängung von PbO durch SrO im dotierten PZT-Mischkristall-System wird durch den Basizitätsunterschied von PbO und SrO hervorgerufen. Der exotherme Charakter dieser Säure-Base-Reaktion hat zur Folge, dass mit zunehmender Temperatur (zum Beispiel beim Sintern) die beschriebenen Gleichgewichtsreaktionen zur Seite der Edukte hin verschoben werden, das heißt auf die linke Seite der Gleichgewichtsreaktionen. Ein Vorteil dieser weitgehend temperaturabhängigen Gleichgewichtsverschiebung besteht beispielsweise darin, dass beim Sintern als Folge der Dotierung mit $(SrO)_a(Nb_2O_5)_{1-a}$ in den Grenzen $1 > a > 2/3$ die Ausbildung einer (zumindest temporär) erhöhten Sauerstoff-Leerstellenkonzentration gefördert wird, was sich sehr positiv auf die Sinterverdichtung und Bildung einer optimierten Gefügestruktur der Keramik auswirkt. Während der Abkühlung nach dem Sintern werden die Gleichgewichtsreaktionen unter Ausscheidung einer dem Dotierungsgrad äquivalenten Menge an PbO zur Seite der Produkte verschoben, das heißt auf die rechte Seite der Gleichgewichtsreaktionen. Besonders vorteilhaft ist dabei die gleichzeitig einhergehende erhebliche Absenkung oder sogar Eliminierung der für die Langzeitstabilität des piezoelektrischen Materials - vor allem während einer Anwendung im elektrischen Feld - ungünstigen erhöhten Sauerstoff-Leerstellenkonzentration. Dabei kann die Wechselwirkung des Dotierstoffs in fester Lösung mit dem PZT-Wirtsgitter den vollständigen Übertritt der Sr-Kationen von den formalen B-Plätzen auf die formalen A-Plätze, das heißt teilweise Substitution von Pb-Kationen mit Koordinationszahl = 12, einschließen.

Mittels hochauflösender festkörperanalytischer Messmethoden wurde der Anteil von Sr-Kationen sowohl auf den formalen A-Plätzen (Koordinationszahl = 12) als auch auf den formalen B-Plätzen (Koordinationszahl = 6) in den hier beschriebenen piezoelektrischen Materialien nach der thermischen Prozessierung analysiert und quantifiziert. Dabei wurden bemerkenswert hohe Konzentrationen von Sr-Kationen auf den formalen B-Plätzen eindeutig nachgewiesen, beispielsweise ein Anteil in Höhe von zirka 10 % des gesamten Gehalts an Sr. Eine Schlussfolgerung dieser Untersuchungen ist, dass die angegebene Reaktion gemäß Gleichung <9> während der Abkühlung nach dem Sintern nicht vollständig zur Seite der Reaktionsprodukte hin abläuft.

Bei nahezu vollständiger Eliminierung der Sauerstoff-Leerstellen verbleibt in einer durch $(SrO)_a(Nb_2O_5)_{1-a}$ in den Grenzen $1 > a > 2/3$ dotierten PZT-Keramik ein beträchtlicher Anteil des Gesamt-Strontiumgehalts auf den B-Plätzen des Perowskit-Mischkristalls des piezoelektrischen Materials, wodurch die - vor allem für eine Anwendung in piezoelektrischen Vielschicht-Aktuatoren - hervorragenden Materialeigenschaften zustande kommen.

Darüber hinaus wird ein piezoelektrisches Material angegeben, das zusätzlich die Zusatzkomponente Z im PZT-Mischkristall-System enthält. Dadurch wird die Modifizierung und Anpassung der piezoelektrischen Eigenschaften an vorgegebene Werte ermöglicht. Die Zusatzkomponente Z kann die im Folgenden angegebenen Verbindungen umfassen:

$$[Pb(Fe^{III}_{2/3}W^{VI}_{1/3})O_3],$$

$[Pb(M^{II}_{1/3}M^{V}_{2/3})O_3]$, wobei $M^{II}$ für Mg, Zn, Co, Ni, Mn oder Cu und $M^V$ für Nb, Ta oder Sb steht,
$[Pb(M^{III}_{1/2}M^{V}_{1/2})O_3]$, wobei $M^{III}$ für Fe, Mn, Cr oder Ga und $M^V$ für Nb, Ta oder Sb steht,
$[Pb(M^{III}_{2/3}M^{VI}_{1/3})O_3]$, wobei $M^{III}$ für Mn, Cr, Ga und $M^{VI}$ für W steht,
$[Pb(Li_{1/4}M^{V}_{3/4})O_3]$, wobei $M^V$ für Nb, Ta oder Sb steht.

Ferner kann das piezoelektrische Material frei von $[Pb(Fe^{III}_{2/3}W^{VI}_{1/3})O_3]$ sein.

Es wird darüber hinaus ein piezoelektrischer Vielschicht-Aktuator angegeben, der mindestens eine dielektrische Schicht und mindestens zwei Innenelektroden umfasst, wobei mindestens eine dielektrische Schicht ein piezoelektrisches Material wie hier beschrieben enthält.

Darüber hinaus wird ein Verfahren zur Herstellung eines piezoelektrischen Bauelements angegeben, wobei das Bauelement das hier beschriebene Material enthält, wobei die Konzentration der Sauerstoff-Leerstellen während des Sinterns des Keramikmaterials erhöht und beim Abkühlen des Keramikmaterials wieder erniedrigt wird.

Das Material wird an folgenden Ausführungsbeispielen näher erläutert.

Beispiel 1:

Die Dotierung einer PZT-Keramik gemäß $Pb(Zr_{0,53}Ti_{0,47})O_3$ mit beispielsweise 3,425 mol-% $(SrO)_{34/41}(Nb_2O_5)_{7/41}$ (dies entspricht 0,5 mol-% $[Sr_4(Sr_{5/3}Nb_{7/3})O_{11,5}V_{O;0,5}]$) und Zugabe von 1 mol-% PbO entsprechend der Formel

$[Pb(Zr_{0,53}Ti_{0,47})O_3]_{0,995}[Sr_4(Sr_{5/3}Nb_{7/3})O_{11,5}V_{O;0,5}]_{0,005} [PbO]_{0,01}$

führt während der thermischen Prozessierung zu einer piezoelektrischen Keramik gemäß der Formel

$$[Pb(Zr_{0,53}Ti_{0,47})O_3]_{0,973}[Sr_4(Sr_{4/3}Nb_{8/3})O_{12}]_{0,00213}$$

$$[Sr(Zr_{0,53}Ti_{0,47})O_3]_{0,017}[PbV_{Pb}(Nb_2O_6)]_{0,003}(PbO)_{0,029}$$

wobei die in eckigen Klammern stehenden Komponenten unter Ausbildung einer Perowskit-Mischkristallphase ineinander löslich und Sauerstoff-Leerstellen nur noch in vernachlässigbar kleinen Konzentrationen vorhanden sind. Als Folge einer graduellen Verdrängung von PbO durch SrO in Verbindung mit einer Freisetzung von $Nb_2O_5$ kommt es in der Keramik zur Ausbildung von Blei-Leerstellen ($V_{Pb}$) auf den formalen A-Plätzen (Pb-Plätze), und zirka 10 % des Gesamt-Strontiumgehalts verbleiben auf den formalen B-Plätzen (Zr/Ti-Plätze) in Nachbarschaft zu Nb-Kationen mit Koordinationszahl 6.

Beispiel 2:

Bezüglich des Dotierstoffs gemäß der Formel $(SrO)_a(Nb_2O_5)_{1-a}$ in den Grenzen $1 > a > 2/3$ können alternativ oder auch zusätzlich verwandte Systeme eingesetzt werden, die einen ähnlichen strukturellen Aufbau aufweisen. Beispielsweise können Verbindungen gemäß der Formel $[(BaO)_{1-p}(CaO)_p]_a[Nb_2O_5]_{1-a}$ im Bereich $1 > a > 2/3$ mit $1 < p < 0$ verwendet werden. In den Grenzen $6/7 \geq a \geq 4/5$ mit entsprechend zugeordnetem Parameter p in den Grenzen $1/3 \geq p \geq 1/4$ kommt es in diesem Fall zur Bildung einer Mischkristall-Phase zwischen dem Kryolith-System gemäß der Formel $Ba_4(Ca_{2-2x/3}Nb_{2+2x/3})O_{11+x}V_{O;1-x}$ mit $0 \leq x \leq 1$ als Dotierstoff und PZT als Wirtsgitter. Dabei unterliegt der Dotierstoff im Mischkristall den analogen temperaturabhängigen Gleichgewichtsreaktionen, wie sie in den Gleichungen <4> bis <6> beschrieben sind.

Im Bereich $1 > a > 6/7$ mit $1 \geq p \geq 0$ reagieren Verbindungen gemäß der Formel $[(BaO)_{1-p}(CaO)_p]_a[Nb_2O_5]_{1-a}$ mit PZT analog zu den Reaktionsgleichungen <1a> und <1b>, bis sich beim Erreichen von $a = 6/7$ mit $p = 1/3$ die Ausbildung einer PZT-Mischkristall-Phase mit $Ba_4(Ca_2Nb_2)O_{11}V_O$ ergibt, einer Verbindung, die im Kryolith-Strukturtyp mit Ca-Kationen auf B-Plätzen auftritt und Sauerstoff-Leerstellen $V_O$ enthält. Die Mitwirkung dieser Kryolith-Komponente im PZT/Dotierstoff-Mischkristall-System kommt im gesamten Bereich innerhalb der Grenzen $1 > a > 6/7$ zum Tragen, das heißt mit dem Einbau von Nb-Kationen auf formalen B-Plätzen geht stets die Möglichkeit der Besetzung von Ca-Kationen auf B-Plätzen einher. Dabei sind die zu den Gleichungen <4> bis <6> analogen temperaturabhängigen Reaktionen in Betracht zu ziehen.

Beispielsweise ergibt die Dotierung einer PZT-Keramik gemäß der Formel $Pb(Zr_{0,52}Ti_{0,48})O_3$ mit 3,425 mol-% $[(BaO)_{12/17}(CaO)_{5/17}]_{34/41}[Nb_2O_5]_{7/41}$ (dies entspricht 0,5 mol-% $[Ba_4(Ca_{5/3}Nb_{7/3})O_{11,5}V_{0,5}]$) und Zugabe von 1 mol-% PbO entsprechend der Formel

$$[Pb(Zr_{0,52}Ti_{0,48})O_3]_{0,995}[Ba_4(Ca_{5/3}Nb_{7/3})O_{11,5}V_{0,5}]_{0,005} [PbO]_{0,01}$$

während der thermischen Prozessierung eine piezoelektrische Keramik gemäß der Formel

$$[Pb(Zr_{0,52}Ti_{0,48})O_3]_{0,973}[Ba_4(Ca_{4/3}Nb_{8/3})O_{12}]_{0,00213}$$
$$[Ba(Zr_{0/52}Ti_{0,48})O_3]_{0,0115}[Ca(Zr_{0,52}Ti_{0,48})O_3]_{0,0055} [PbV_{Pb}(Nb_2O_6)]_{0,003}(PbO)_{0,029}$$

wobei zirka 34 % des Gesamt-Calciumgehalts auf den formalen B-Plätzen des Perowskit-Mischkristalls eingebaut sind.

In analoger Weise kann an Stelle von $[(BaO)_{1-p}(CaO)_p]_a[Nb_2O_5]_{1-a}$ in den Grenzen $1 > a > 2/3$ auch ein Materialsystem gemäß der Formel $[(BaO)_{1-p}(SrO)_p]_a[Nb_2O_5]$ oder auch ein Materialsystem gemäß der Formel $[(SrO)_{1-p}(CaO)_p]_a[Nb_2O_5]$ als Dotierstoff eingesetzt werden, wobei sich die in den Grenzen $6/7 \geq a \geq 4/5$ mit entsprechend zugeordnetem Parameter p in den Grenzen $1/3 \geq p \geq 1/4$ gebildeten Verbindungen aus den Kryolith-Systemen $Ba_4(Ca_{2-x/3}Nb_{2+2x/3})O_{11+x}V_{O;1-x}$ beziehungsweise $Sr_4(Ca_{2-2x/3}Nb_{2+2x/3})O_{11+x}V_{O;1-x}$ mit $0 \leq x \leq 1$ im PZT-Wirtsgitter unter Mischkristallbildung lösen und in temperaturabhängigen Gleichgewichtsreaktionen analog zu den Gleichungen <4> bis <6> mit PZT in Wechselwirkung treten können.

Zur Herstellung des hier beschriebenen piezoelektrischen Materials wird eine Mischung aus $Pb_3O_4$ oder $PbCO_3$ mit $TiO_2$ und $ZrO_2$ oder wahlweise einem $(Zr_{1-y}Ti_y)O_2$-Precursor, sowie $SrCO_3$ und $Nb_2O_5$, und gegebenenfalls weiteren Zusätzen wie zum Beispiel $Pb(Fe^{III}_{2/3}W^{VI}_{1/3})O_3$ bereit gestellt. Beispielhafte Zusammensetzungen sind in den Tabellen 1 bis 2 aufgeführt. Alternativ kann $SrCO_3$ auch durch einen entsprechenden Anteil an $BaCO_3$ oder $CaCO_3$ ersetzt sein, beziehungsweise es wird $BaCO_3$ anstelle von $SrCO_3$ als Rohstoff in einer anteiligen Kombination mit $SrCO_3$ beziehungsweise $CaCO_3$ eingesetzt. Alternativ kann auch eine Mischung benutzt werden, in der die ErdalkaliCarbonate durch Erdalkali-Titanate wie zum Beispiel $SrTiO_3$, $BaTiO_3$ oder $CaTiO_3$ ersetzt sind, oder indem man die Mischung entsprechend der gewünschten Zusammensetzung mit dem jeweiligen Anteil an vorgefertigter Verbindung aus den beschriebenen Kryolith-Systemen, wie beispielsweise gemäß den Formeln

$Sr_4(Sr_{2-2x/3}Nb_{2+2x/3})O_{11+x}V_{O;1-x}$,
$Ba_4(Sr_{2-2x/3}Nb_{2+2x/3})O_{11+x}V_{O;1-x}$,
$Ba_4(Ca_{2-2x/3}Nb_{2+2x/3})O_{11+x}V_{O;1-x}$ oder
$Sr_4(Ca_{2-2x/3}Nb_{2+2x/3})O_{11+x}V_{O;1-x}$ mit $0 \leq x \leq 1$

versetzt.

In den Tabellen 1 bis 2 sind beispielhafte Zusammensetzungen von Materialien mit partieller Dotierung von Sr beziehungsweise Ca-Kationen auf formalen B-Plätzen in der entstehenden PZT-Mischkristall-Phase mit Perowskit-Struktur aufgeführt.

Soweit für den Parameter d zwei Zahlenwerte angegeben sind, sind diese jeweils für sich in Kombination mit den in derselben Zeile stehenden übrigen Parameterwerte als separate Ausführungsbeispiele zu sehen.

Tabelle 1:

| $[Pb(Zr_{1-y}Ti_y)O_3]_{1-c}[(SrO)_a(Nb_2O_5)_{1-a}]_c \cdot 0,01\ PbO$ | | |
|---|---|---|
| 1-y = 0,53 | a = 34/41 | c = 0,0255 |
| 1-y = 0,53 | a = 34/41 | c = 0,0342 |
| 1-y = 0,53 | a = 34/41 | c = 0,0443 |
| 1-y = 0,535 | a = 34/41 | c = 0,0255 |
| 1-y = 0,535 | a = 34/41 | c = 0,0342 |
| 1-y = 0,535 | a = 34/41 | c = 0,0443 |

| $[Pb(Zr_{1-y}Ti_y)O_3]_{1-c-d}[Pb(Fe^{III}_{2/3}W^{VI}_{1/3})O_3]_d\ [(SrO)_a(Nb_2O_5)_{1-a}]_c \cdot 0,01\ PbO$ | | | | |
|---|---|---|---|---|
| 1-y = 0, 53 | a = 34/41 | c = 0,0255 | d = 0,003 | oder 0,008 |
| 1-y = 0,53 | a = 34/41 | c = 0,0342 | d = 0,003 | oder 0,008 |
| 1-y = 0,53 | a = 34/41 | c = 0,0443 | d = 0,003 | oder 0,008 |
| 1-y = 0,535 | a = 34/41 | c = 0,0255 | d = 0,003 | oder 0,008 |
| 1-y = 0,535 | a = 34/41 | c = 0,0342 | d = 0,003 | oder 0,008 |
| 1-y = 0,535 | a = 34/41 | c = 0,0443 | d = 0,003 | oder 0,008 |

Tabelle 2:

| $[Pb(Zr_{1-y}Ti_y)O_3]_{1-c}\{[(BaO)_{1-p}(CaO)_p]_a[Nb_2O_5]_{1-a}\}_c \cdot 0,01\ PbO$ | | | |
|---|---|---|---|
| 1-y = 0,53 | a = 34/41 | c = 0,0255 | p = 5/17 |
| 1-y = 0,53 | a = 34/41 | c = 0,0342 | p = 5/17 |
| 1-y = 0,53 | a = 34/41 | c = 0,0443 | p = 5/17 |
| 1-y = 0,535 | a = 34/41 | c = 0,0255 | p = 5/17 |
| 1-y = 0,535 | a = 34/41 | c = 0,0342 | p = 5/17 |
| 1-y = 0,535 | a = 34/41 | c = 0,0443 | p = 5/17 |

| $[Pb(Zr_{1-y}Ti_y)O_3]_{1-c-d}[Pb(Fe^{III}_{2/3}W^{VI}_{1/2})O_3]_d\ \{[(BaO)_{1-p}(CaO)_p]_a[Nb_2O_5]_{1-a}\}_c \cdot 0,01\ PbO$ | | | | |
|---|---|---|---|---|
| 1-y = 0,53 | a = 34/41 | c = 0,0255 | p = 5/17 | d = 0,003 oder 0,008 |
| 1-y = 0,53 | a = 34/41 | c = 0,0342 | p = 5/17 | d = 0,003 oder 0,008 |
| 1-y = 0,53 | a = 34/41 | c = 0,0443 | p = 5/17 | d = 0,003 oder 0,008 |

(fortgesetzt)

| $[Pb(Zr_{1-y}Ti_y)O_3]_{1-c-d}[Pb(Fe^{III}_{2/3}W^{VI}_{1/2})O_3]_d \{[(BaO)_{1-p}(CaO)_p]_a[Nb_2O_5]_{1-a}\}_c \bullet 0,01\ PbO$ | | | | |
|---|---|---|---|---|
| 1-y = 0,535 | a = 34/41 | c = 0,0255 | p = 5/17 | d = 0,003 oder 0,008 |
| 1-y = 0,535 | a = 34/41 | c = 0,0342 | p = 5/17 | d = 0,003 oder 0,008 |
| 1-y = 0,535 | a = 34/41 | c = 0,0443 | p = 5/17 | d = 0,003 oder 0,008 |

Derartige Mischungen werden vorzugsweise in Bezug auf das Zrzu-Ti Verhältnis auf die morphotrope Phasengrenze (MPG) eingestellt und bei Bedarf mit einem geringen Überschuss an PbO als Sinterhilfsmittel versetzt.

Nach trocken- oder nass-chemischer Homogenisierung werden die Mischungen bei typischerweise 900-1000 °C kalziniert. Mit Hilfe einer Feinmahlung lässt sich die Sinteraktivität an die gewünschte Sintertemperatur anpassen, beispielsweise im Bereich von zirka 900-1200°C.

Das erhaltene Pulvermaterial wird unter Verwendung von Hilfsmitteln wie beispielsweise Dispergatoren und eventuell weiteren Additiven in eine Pulversuspension mit typischer Weise zirka 50-80 % Feststoffgehalt überführt. Es kann anschließend zum Beispiel durch Sprühtrocknung in ein pressfähiges Granulat überführt werden, oder es kann beispielsweise auch direkt zu keramischen Grünfolien verarbeitet werden. Zur Einstellung der für den weiteren Verarbeitungsprozess erforderlichen Eigenschaften können den Pulversuspensionen typischer Weise zum Beispiel 2-15 % an Bindern sowie bei Bedarf auch weitere Additive zugesetzt werden.

Als Probekörper werden scheibenförmige Presslinge aus Pulvergranulat hergestellt, während rechteckige Mehrlagenplättchen, im folgenden MLPs genannt, hergestellt werden durch Stapeln und Laminieren von keramischen Grünfolien. Die Probenkörper werden mit üblichen Methoden und Prozessen entbindert. Als Probenkörper dienen auch piezoelektrische Vielschicht-Aktuatoren, die bis zu mehrere Hundert Innenelektroden enthalten können. Im Fall von Innenelektroden aus Cu oder anderen unedlen Metallen ist während der thermischen Prozessierung auf eine genaue Kontrolle und Steuerung in der Ofenatmosphäre zu achten, um eine Oxidation der Innenelektroden beziehungsweise eine Reduktion der Keramik zu verhindern.

Die beschriebenen piezoelektrischen Materialien ermöglichen eine hohe Sinterverdichtung zu Keramiken mit einer für die piezoelektrischen und elektromechanischen Eigenschaften sehr vorteilhaften Gefügestruktur. Nach dem Kontaktieren der Probenkörper zum Beispiel durch Sputtern von Gold-Elektroden werden die dielektrischen und speziell die piezoelektrischen Eigenschaften gemessen. Bei piezoelektrischen Vielschicht-Aktuatoren erfolgt das Kontaktieren vorteilhafter Weise durch Aufbringen und Einbrennen von geeigneten Metallpasten. Die Polung der piezoelektrischen Materialien mit einer CurieTemperatur im Bereich von zirka $T_C \sim 250\text{-}380$ °C erfolgt typischer Weise mit zirka 2 kV/mm.

Einige der mit derartigen verschiedenen Probekörpern erhaltenen Messwerte und Eigenschaften sind in Tabellen 3 bis 7 für piezoelektrische Materialien beispielhaft zusammengestellt.

Neben der Dielektrizitätskonstante $\varepsilon$ wurde entsprechend der für den piezoelektrischen Effekt geltenden Beziehung $S_3 = d_{33} \times E_3$ die Dehnung S unter Einwirkung der elektrischen Feldstärke E zur Ermittlung der piezoelektrischen Konstante $d_{33}$ gemessen, wobei hier der Index "3" die Richtung der durch Polung eingestellten polaren Achse sowie der angelegten Feldstärke beschreibt. Ferner sind die Messwerte für den dielektrischen Verlust angegeben. Der Verlust ist dabei das Verhältnis aus elektrischer Verlustenergie zur elektrischen Gesamtenergie und wird der von der gemessenen Hysteresekurve eingeschlossenen Fläche entnommen.

Tabelle 3:

| Kleinsignal- und Großsignal-Messwerte für scheibenförmige MLP-Proben (Durchmesser: 13 mm, Höhe: 1 mm) und für Vielschicht-Aktuatoren (350 Ag/Pd-Innenelektroden, Dicke der dielektrischen Schichten: 80 $\mu$m, Aktuatorfläche: $3,5 \times 3,5$ mm$^2$) mit erfindungsgemäßem piezoelektrischen Material gemäß der Formel $[Pb(Zr_{1-y}Ti_y)O_3]_{0,973}[Sr_4(Sr_{4/3}Nb_{8/3})O_{12}]_{0,00213}$ $[Sr(Zr_{1-y}Ti_y)O_3]_{0,017}[PbV_{Pb}(Nb_2O_6)]_{0,003}(PbO)_{0,029}$ | | | | | |
|---|---|---|---|---|---|
| 1-y | Probe | Feldstärke [V/mm] | $\varepsilon$ | d33 [pm/V] | Verlust |
| 0,52 | MLP | 2000 | 2588 | 634 | 0,455 |
| 0,525 | MLP | 2000 | 2672 | 658 | 0,445 |
| 0,53 | MLP | 2000 | 2687 | 677 | 0,446 |
| 0,535 | MLP | 2000 | 1851 | 599 | 0,431 |
| 0,54 | MLP | 2000 | 2206 | 650 | 0,451 |

(fortgesetzt)

| Kleinsignal- und Großsignal-Messwerte für scheibenförmige MLP-Proben (Durchmesser: 13 mm, Höhe: 1 mm) und für Vielschicht-Aktuatoren (350 Ag/Pd-Innenelektroden, Dicke der dielektrischen Schichten: 80 $\mu$m, Aktuatorfläche: $3,5 \times 3,5$ mm$^2$) mit erfindungsgemäßem piezoelektrischen Material gemäß der Formel $[Pb(Zr_{1-y}Ti_y)O_3]_{0,973}[Sr_4(Sr_{4/3}Nb_{8/3})O_{12}]_{0,00213}$ $[Sr(Zr_{1-y}Ti_y)O_3]_{0,017}[PbV_{Pb}(Nb_2O_6)]_{0,003}(PbO)_{0,029}$ | | | | | |
|---|---|---|---|---|---|
| 1-y | Probe | Feldstärke [V/mm] | $\varepsilon$ | d33 [pm/V] | Verlust |
| 0,52 | MLP | 1 | 1598 | | 0,0154 |
| 0,525 | MLP | 1 | 1670 | | 0,0150 |
| 0,53 | MLP | 1 | 1419 | | 0,0193 |
| 0,535 | MLP | 1 | 1070 | | 0,0206 |
| 0,54 | MLP | 1 | 1341 | | 0,0184 |
| 0,52 | Aktuator | 2000 | 3379 | 701 | 0,408 |
| 0,52 | Aktuator | 1 | 1669 | | 0,0222 |

Tabelle 4:

| Klein- und Großsignal-Messwerte für scheibenförmige MLP-Proben (Durchmesser: 13 mm, Höhe: 1 mm) mit piezoelektrischem Material gemäß der Formel $[Pb(Zr_{1-y}Ti_y)O_3]_{0,974}[Sr_4(Sr_{4/3}Nb_{8/3})O_{12}]_{0,00183}$ $[Sr(Zr_{1-y}Ti_y)O_3]_{0,0146}[PbV_{Pb}(NbO_3)]_{0,0097}(PbO)_{0,01}$ | | | | | |
|---|---|---|---|---|---|
| 1-y | Probe | Feldstärke [V/mm] | $\varepsilon$ | $d_{33}$ [pm/V] | Verlust |
| 0,53 | MLP | 2000 | 2724 | 659 | 0,476 |
| 0,53 | MLP | 1 | 2881 | 722 | 0,469 |

Tabelle 5:

| Klein- und Großsignal-Messwerte für scheibenförmige MLP-Proben (Durchmesser: 13 mm, Höhe: 1 mm) mit piezoelektrischem Material gemäß der Formel $[Pb(Zr_{1-y}Ti_y)O_3]_{0,973}[Sr_4(Sr_{4/3}Nb_{8/3})O_{12}]_{0,0020}$ $[Sr(Zr_{1-y}Ti_y)O_3]_{0,0161}[PbV_{Pb}(NbO_3)]_{0,0117}(PbO)_{0,0078}$ | | | | | |
|---|---|---|---|---|---|
| 1-y | Probe | Feldstärke [V/mm] | E | $d_{33}$ [pm/V] | Verlust |
| 0,53 | MLP | 2000 | 2667 | 631 | 0,440 |
| 0,53 | MLP | 1 | 1683 | | 0,0165 |

Tabelle 6:

| Klein- und Großsignal-Messwerte für scheibenförmige MLP-Proben (Durchmesser: 13 mm, Höhe: 1 mm) mit piezoelektrischem Material gemäß der Formel $[Pb(Zr_{1-y}Ti_y)O_3]_{0,973}[Sr_4(Sr_{4/3}Nb_{8/3})O_{12}]_{0,0020}$ $[Sr(Zr_{1-y}Ti_y)O_3]_{0,0161}[PbV_{Pb}(NbO_3)]_{0,0093}(PbO)_{0,010}$ | | | | | |
|---|---|---|---|---|---|
| 1-y | Probe | Feldstärke [V/mm] | $\varepsilon$ | $d_{33}$ [pm/V] | Verlust |
| 0,535 | MLP | 2000 | 2870 | 674 | 0,497 |
| 0,535 | MLP | 1 | 1698 | | 0,0167 |

Tabelle 7:

| Klein- und Großsignal-Messwerte für scheibenförmige MLP-Proben (Durchmesser: 13 mm, Höhe: 1 mm) mit piezoelektrischem Material gemäß der Formel $[Pb(Zr_{1-y}Ti_y)O_3]_{0,973}[Sr_4(Sr_{4/3}Nb_{8/3})O_{12}]_{0,0020}$ $[Sr(Zr_{1-y}Ti_y)O_3]_{0,0161}[PbV_{Pb}(NbO_3)]_{0,0093}(PbO)_{0,010}$ | | | | | |
|---|---|---|---|---|---|
| 1-y | Probe | Feldstärke [V/mm] | $\varepsilon$ | $d_{33}$ [pm/V] | Verlust |
| 0,535 | MLP | 2000 | 2881 | 722 | 0, 469 |
| 0,535 | MLP | 1 | 1727 | | 0,0181 |

Tabelle 8:

| Klein- und Großsignal-Messwerte für scheibenförmige MLP-Proben (Durchmesser: 13 mm, Höhe: 1 mm) mit piezoelektrischem Material gemäß der Formel $[Pb(Zr_{1-y}Ti_y)O_3]_{0,973}[Ba_4(Ca_{4/3}Nb_{8/3})O_{12}]_{0,00213}$ $[Ba(Zr_{1-y}Ti_y)O_3]_{0,0115}[Ca((Zr_{1-y}Ti_y)O_3]_{0,0055}[Pb_{0,5}V_{Pb;0,5}(NbO_3)]_{0,006}(PbO)_{0,02}$ | | | | | |
|---|---|---|---|---|---|
| 1-y | Probe | Feldstärke [V/mm] | $\varepsilon$ | $d_{33}$ [pm/V] | Verlust |
| 0,535 | MLP | 2000 | 2609 | 610 | 0,510 |
| 0,535 | MLP | 1 | 1228 | | 0,0201 |

Durch die entsprechende Wahl der Ionen für $M_1$ bzw. $M_2$ und der Parameter a, p und c konnten für die Dielektrizitätskonstante $\varepsilon$ und die piezoelektrische Konstante $d_{33}$ Werte erzielt werden, wie sie zuvor in ähnlichen Materialien nur durch Zusatz einer weiteren Komponente erreicht wurden. Als weitere Komponente wurden beispielsweise $KNbO_3$ oder Komplexe benutzt, welche zusätzliche (Schwer-)Metalle, wie beispielsweise Fe, enthalten.

Die für die Messungen der Tabelle 3 bis 8 verwendeten Materialien hingegen bestehen vorzugsweise ausschließlich aus der Komponente P, D, PbO und deren Reaktionsprodukten. Auf den Zusatz einer weiteren Komponente Z konnte in diesen Fällen gänzlich verzichtet werden (d = 0).

**Patentansprüche**

1.  Piezoelektrisches Material,
    das ein Material mit der Summenformel $P_{1-c-d}D_cZ_d$ enthält, wobei gilt:

    0,0255 < c < 0,0443 und $0 \leq d \leq 0,5$,

        - wobei P für die Zusammensetzung $Pb(Zr_{1-y}Ti_y)O_3$ steht und wobei gilt: $0,50 \leq 1\text{-}y \leq 0,60$,
        - wobei Z für eine Zusatzkomponente vom Perowskit-Strukturtyp steht,

- wobei D für ein Material gemäß der allgemeinen Formel $[(M_1O)_{1-p}(M_2O)_p]_a[Nb_2O_5]_{1-a}$ steht, wobei $M_1$ für $Ba_{1-t}Sr_t$ mit $0 \leq t \leq 1$ und $M_2$ für Strontium und/oder Calcium steht und wobei gilt: $2/3 < a < 1$ und $0 < p < 1$,
- wobei das Material D den Kryolith-Strukturtyp enthält.

2. Piezoelektrisches Material nach Anspruch 1,
   das einen Mischkristall enthält, umfassend die Komponente P mit der Struktur des Perowskit-Typs $ABO_3$ als Wirtsgitter und die Komponente D, wobei zumindest ein Teil der $M_2$-Kationen die formalen B-Plätze des PZT-Perowskit-Wirtsgitters besetzt.

3. Piezoelektrisches Material nach einem der Ansprüche 1 oder 2,
   bei dem gilt: $6/7 < a < 1$.

4. Piezoelektrisches Material nach einem der Ansprüche 1 bis 3,
   bei dem gilt: $2/3 < a < 4/5$.

5. Piezoelektrisches Material nach einem der Ansprüche 1 oder 2,
   bei dem gilt: $4/5 \leq a \leq 6/7$ und $1/4 \leq p \leq 1/3$, und bei dem die Komponente D mit Kryolith-Struktur gemäß der allgemeinen Formel
   $(M_1)_4[(M_2)_{2-2x/3}Nb_{2+2x/3}]O_{11+x}V_{O;1-x}$ mit $0 \leq x \leq 1$, wobei $V_O$ für Sauerstoff-Leerstellen steht,
   eine feste Lösung mit dem PZT-Wirtsgitter bildet,
   wobei gilt: $a = 22/35 + 24p/35$ und $a = 6/7 - 2x/35$.

6. Piezoelektrisches Material nach einem der vorherigen Ansprüche,
   bei dem eine Kryolithverbindung gemäß der Formel
   $(M_1)_4[(M_2)_2Nb_2]O_{11}V_{O;1}$ eine feste Lösung mit dem PZT-Wirtsgitter bildet.

7. Piezoelektrisches Material nach einem der Ansprüche 1 bis 3,
   wobei die Kryolithverbindung Bestandteil der Komponente D ist und der Überschuss an MO der Komponente D mit der Komponente P zumindest teilweise zu $M(Zr_{1-y}Ti_y)O_3$ und PbO reagiert ist, wobei M für $M_1$ oder $M_2$ steht.

8. Piezoelektrisches Material nach einem der Ansprüche 1, 2 oder 4,
   wobei die Kryolithverbindung Bestandteil der Komponente D ist und der Überschuss an $Nb_2O_5$ der Komponente D zumindest teilweise mit zusätzlich vorhandenem PbO zu Bleiniobat reagiert ist.

9. Piezoelektrisches Material nach einem der Ansprüche 1 bis 8,
   das $M(Zr_{1-y}Ti_y)O_3$ enthält als Produkt einer Reaktion der Komponente D mit dem PZT-Wirtsgitter, wobei M für $M_1$ oder $M_2$ steht.

10. Piezoelektrisches Material nach einem der Ansprüche 1 bis 9,
    das $Sr(Zr_{1-y}Ti_y)O_3$ enthält als Produkt einer Reaktion der Komponente P mit der Komponente D.

11. Piezoelektrisches Material nach einem der Ansprüche 1 bis 3,
    wobei für $6/7 < a < 1$ der Überschuss an MO der Komponente D mit der Komponente P zumindest teilweise zu $M(Zr_{1-y}Ti_y)O_3$ und PbO reagiert ist, wobei M für $M_1$ oder $M_2$ steht.

12. Piezoelektrisches Material nach einem der Ansprüche 1, 2 oder 4,
    wobei für $2/3 < a < 4/5$ der Überschuss an $Nb_2O_5$ der Komponente D zumindest teilweise mit zusätzlich vorhandenem PbO zu Bleiniobat reagiert ist.

13. Piezoelektrischer Vielschicht-Aktuator,
    umfassend mindestens eine dielektrische Schicht und mindestens zwei Elektroden,
    wobei mindestens eine dielektrische Schicht ein piezoelektrisches Material nach einem der Ansprüche 1 bis 12 enthält.

14. Verfahren zur Herstellung eines piezoelektrischen Bauelements enthaltend ein Material nach einem der vorherigen Ansprüche,
    wobei die Konzentration der Sauerstoff-Leerstellen während des Sinterns des Keramikmaterials erhöht und beim Abkühlen des Keramikmaterials wieder erniedrigt wird.

**Claims**

1. Piezoelectric material,
   which contains a material with the molecular formula $P_{1-c-d}DcZ_d$, where:

$$0.0255 < c < 0.0443 \text{ and } 0 \leq d \leq 0.5,$$

   - wherein P represents the composition $Pb(Zr_{1-y}Ti_y)O_3$, and where: $0.50 \leq 1-y \leq 0.60$,
   - wherein Z represents an additional component of the perovskite type of structure,
   - wherein D represents a material according to the general formula $[(M_1O)_{1-p}(M_2O)_p]_a[Nb_2O_5]_{1-a}$, wherein $M_1$ represents $Ba_{1-t}Sr_t$, where $0 \leq t \leq 1$, and $M_2$ represents strontium and/or calcium, and where: $2/3 < a < 1$ and $0 < p < 1$,
   - wherein the material D contains the cryolite type of structure.

2. Piezoelectric material according to Claim 1,
   which contains a mixed crystal comprising the component P with the structure of the perovskite type $ABO_3$ as the host lattice and the component D, wherein at least some of the $M_2$ cations occupy the formal B sites of the PZT perovskite host lattice.

3. Piezoelectric material according to either of Claims 1 and 2,
   in which: $6/7 < a < 1$.

4. Piezoelectric material according to one of Claims 1 to 3,
   in which: $2/3 < a < 4/5$.

5. Piezoelectric material according to either of Claims 1 and 2,
   in which: $4/5 \leq a \leq 6/7$ and $1/4 \leq p \leq 1/3$, and in which the component D with a cryolite structure according to the general formula
   $(M_1)_4[(M_2)_{2-2x/3}Nb_{2+2x/3}]O_{11+x}V_{O;1-x}$, where $0 \leq x \leq 1$, wherein $V_O$ represents oxygen vacancies,
   forms a solid solution with the PZT host lattice, where: $a = 22/35 + 24p/35$ and $a = 6/7 - 2x/35$.

6. Piezoelectric material according to one of the preceding claims,
   in which a cryolite compound according to the formula $(M_1)_4[(M_2)_2Nb_2]O_{11}V_{O;1}$ forms a solid solution with the PZT host lattice.

7. Piezoelectric material according to one of Claims 1 to 3,
   wherein the cryolite compound is a constituent of the component D and the excess of MO of the component D is reacted at least partially with the component P to form $M(Zr_{1-y}Ti_y)O_3$ and PbO, wherein M represents $M_1$ or $M_2$.

8. Piezoelectric material according to one of Claims 1, 2 or 4,
   wherein the cryolite compound is a constituent of the component D and the excess of $Nb_2O_5$ of the component D is reacted at least partially with additionally present PbO to form lead niobate.

9. Piezoelectric material according to one of Claims 1 to 8,
   which contains $M(Zr_{1-y}Ti_y)O_3$ as the product of a reaction between the component D and the PZT host lattice, wherein M represents $M_1$ or $M_2$.

10. Piezoelectric material according to one of Claims 1 to 9,
    which contains $Sr(Zr_{1-y}Ti_y)O_3$ as the product of a reaction between the component P and the component D.

11. Piezoelectric material according to one of Claims 1 to 3,
    wherein, for $6/7 < a < 1$, the excess of MO of the component D is reacted at least partially with the component P to form $M(Zr_{1-y}Ti_y)O_3$ and PbO, wherein M represents $M_1$ or $M_2$.

12. Piezoelectric material according to one of Claims 1, 2 or 4,
    wherein, for $2/3 < a < 4/5$, the excess of $Nb_2O_5$ of the component D is reacted at least partially with additionally present PbO to form lead niobate.

13. Piezoelectric multi-layer actuator,
comprising at least one dielectric layer and at least two electrodes,
wherein at least one dielectric layer contains a piezoelectric material according to one of Claims 1 to 12.

14. Method for producing a piezoelectric component containing a material according to one of the preceding claims, wherein the concentration of the oxygen vacancies is increased during the sintering of the ceramic material and lowered again during the cooling of the ceramic material.

**Revendications**

1. Matériau piézoélectrique qui contient un matériau de formule globale $P_{1-c-d}D_cZ_d$, dans laquelle :

$$0,0255 < c < 0,0443 \text{ et } 0 \leq d \leq 0,5,$$

P représentant le composé $Pb(Zr_{1-y}Ti_y)O_3$, avec $0,50 \leq 1-y \leq 0,60$,
Z représentant un composant supplémentaire à structure de type perovskite,
D représentant un matériau de formule générale $[(M_1O)_{1-p}(M_2O)_p]_a[Nb_2O_5]_{1-a}$ dans laquelle $M_1$ représente $Ba_{1-t}Sr_t$ avec $0 \leq t \leq 1$ et $M_2$ le strontium et/ou le calcium, avec $2/3 < a < 1$ et $0 < p < 1$,
le matériau D contenant une structure de type cryolithe.

2. Matériau piézoélectrique selon la revendication 1, qui contient un cristal mixte comprenant le composant P à structure de type perovskite $ABO_3$ comme structure hôte et le composant D, au moins une partie des cations $M_2$ occupant les emplacements formels B du réseau hôte de perovskite PZT.

3. Matériau piézoélectrique selon l'une des revendications 1 ou 2, dans lequel $6/7 < a < 1$.

4. Matériau piézoélectrique selon l'une des revendications 1 à 3, dans lequel $2/3 < a < 4/5$.

5. Matériau piézoélectrique selon l'une des revendications 1 ou 2, dans lequel $4/5 \leq a \leq 6/7/$ et $1/4 \leq p \leq 1/3$ et dans lequel le composant D à structure de cryolithe de formule générale $(M_1)_4[(M_2)_{2-2x/3}Nb_{2+2x/3}]O_{11+x}V_{O;1-x}$ avec $0 \leq x \leq 1$, $V_O$ représentant les emplacements vides d'oxygène, forme avec le réseau hôte PZT une solution solide dans laquelle $a = 22/35 + 24p/35$ et $a = 6/7 - 2x/35$.

6. Matériau piézoélectrique selon l'une des revendications précédentes, dans lequel un composé de cryolithe de formule $(M_1)_4[(M_2)_2Nb_2]O_{11}V_{O;1}$ forme une solution solide avec le réseau hôte PZT.

7. Matériau piézoélectrique selon l'une des revendications 1 à 3, dans lequel le composé de cryolithe fait partie du composant D et l'excès en MO du composant D réagit au moins en partie avec le composant P pour former $M(Zr_{1-y}Ti_y)O_3$ et PbO, M représentant $M_1$ ou $M_2$.

8. Matériau piézoélectrique selon l'une des revendications 1, 2 ou 4, dans lequel le composé de cryolithe fait partie du composant D et l'excès de $Nb_2O_5$ du composant D réagit au moins en partie avec le PbO présent en supplément pour former du niobate de plomb.

9. Matériau piézoélectrique selon l'une des revendications 1 à 8, qui contient $M(Zr_{1-y}Ti_y)O_3$ comme produit d'une réaction du composant D avec le réseau hôte de PZT, M représentant $M_1$ ou $M_2$.

10. Matériau piézoélectrique selon l'une des revendications 1 à 9, qui contient $Sr(Zr_{1-y}Ti_y)O_3$ comme produit d'une réaction du composant P avec le composant D.

11. Matériau piézoélectrique selon l'une des revendications 1 à 3, dans lequel pour $6/7 < a < 1$, l'excès en MO du composant D réagit au moins en partie avec le composant P pour former $M(Zr_{1-y}Ti_y)O_3$ et PbO, M représentant $M_1$ ou $M_2$.

12. Matériau piézoélectrique selon l'une des revendications 1, 2 ou 4, dans lequel pour $2/3 < a < 4/5$, l'excès de $Nb_2O_5$ du composant D réagit au moins en partie avec le PbO présent en supplément pour former du niobate de plomb.

13. Actionneur piézoélectrique multicouche, comprenant au moins une couche diélectrique et au moins deux électrodes, au moins une couche diélectrique contenant un matériau piézoélectrique selon l'une des revendications 1 à 12.

14. Procédé de fabrication d'un composant piézoélectrique contenant un matériau selon l'une des revendications précédentes, la concentration des emplacements vides en oxygène étant augmentée pendant le frittage du matériau céramique et étant de nouveau abaissée lors du refroidissement du matériau céramique.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102004002204 A1
- WO 2005069396 A